# EUROPÄISCHE PATENTANMELDUNG

(11) **EP 1 605 311 A2**
(43) Veröffentlichungstag der Anmeldung: **14.12.2005**
(21) Anmeldenummer: 05010584.0
(22) Anmeldetag: 17.05.2005
(51) Int. Cl.: G03F 7/20

(54) **Beleuchtungseinrichtung mit einem Lichtmischer zur Homogenisierung von Strahlungsverteilungen**

(30) Priorität: 10.06.2004 US 578521 P
(71) Anmelder: Carl Zeiss SMT AG, 73447 Oberkochen (DE)
(72) Erfinder: Fiolka, Damian, 73447 Oberkochen (DE); Singer, Wolfgang, 73431 Aalen (DE); Wangler, Johannes, 89551 Königsbronn (DE)
(74) Vertreter: Schwanhäusser, Gernot

(57) **Zusammenfassung**

Eine Beleuchtungseinrichtung einer mikrolithographischen Projektionsbelichtungsanlage enthält einen Lichtmischer (10; 210) zur Homogenisierung von Strahlungsverteilungen. Dieser kann z.B. mindestens eine ebene Strahlteilerschicht (16; 216a, 216b) umfassen, die zwischen zwei transparenten Teilelementen (12, 14) parallel zu einer optischen Achse (OA) der Beleuchtungseinrichtung (IS) angeordnet ist. Eine alternative Variante für einen Lichtmischer enthält mindestens eine Reihe (R1 bis R3; R1' bis R5') von Strahlteilern (ST11, ST12, ST13, ST21, ST22, ST23, ST31, ST32, ST33), wobei in der mindestens einen Reihe die Strahlteiler parallel zueinander, in einem Neigungswinkel zu einer eingangsseitigen optischen Achse (OA1) der Beleuchtungseinrichtung (IS) und in einer zu der eingangsseitigen optischen Achse (OA1) senkrechten Richtung versetzt hintereinander angeordnet sind.

## Beschreibung

### HINTERGRUNG der Erfindung

### 1. Gebiet der Erfindung

Die Erfindung betrifft eine Beleuchtungseinrichtung einer mikrolithographischen Projektionsbelichtungsanlage mit einem Lichtmischer zur Homogenisierung von Strahlungsverteilungen.

### 2. Beschreibung des Standes der Technik

Bei der Herstellung mikrostrukturierter Bauelemente werden auf ein geeignetes Substrat, bei dem es sich beispielsweise um einen Silizium-Wafer handeln kann, mehrere strukturierte Schichten aufgebracht. Zur Strukturierung der Schichten werden diese zunächst mit einem Photolack bedeckt, der für Licht eines bestimmten Wellenlängenbereiches, z.B. Licht im tiefen ultravioletten Spektralbereich (DUV, *deep ultraviolet),* empfindlich ist. Anschließend wird der so beschichtete Wafer in einer Projektionsbelichtungsanlage belichtet. Dabei wird ein Muster aus Strukturen, das sich auf einer Maske befindet, auf den Photolack mit Hilfe eines Projektionsobjektivs abgebildet.

Nach dem Entwickeln des Photolacks wird der Wafer einem Ätz- oder Abscheideprozeß unterzogen, wodurch die oberste Schicht entsprechend dem Muster auf der Maske strukturiert wird. Der noch verbliebene Photolack wird dann von den verbleibenden Teilen der Schicht entfernt. Dieser Prozeß wird so oft wiederholt, bis alle Schichten auf dem Wafer aufgebracht sind.

Die Leistungsfähigkeit der verwendeten Projektionsbelichtungsanlagen wird nicht nur durch die Abbildungseigenschaften des Projektionsobjektivs, sondern auch durch die Eigenschaften einer dem Projektionsobjektiv vorgeschalteten Beleuchtungseinrichtung bestimmt. Diese hat die Aufgabe, ein Projektionslichtbündel zu erzeugen und auf die zu projizierende Maske zu richten. Die Beleuchtungseinrichtung enthält zu diesem Zweck eine Lichtquelle, z.B. einen gepulst betriebenen Laser, sowie mehrere optische Elemente, die aus dem von der Lichtquelle bereitgestellten Licht ein Projektionslichtbündel mit den gewünschten Eigenschaften erzeugen.

Zu diesen Eigenschaften zählt u.a. die Homogenität des auf die Maske gerichteten Projektionslichtbündels. Im allgemeinen soll nämlich jeder Punkt auf der Maske mit der gleichen Intensität und der gleichen Beleuchtungswinkelverteilung beleuchtet werden. Schwankungen dieser Größen führen in der Regel zu unerwünschten Strukturbreitenschwankungen der herzustellenden Bauteile.

Deswegen sind in Beleuchtungseinrichtungen häufig Lichtmischer vorgesehen, die eine auftreffende Strahlungsverteilung homogenisieren. Die Aufgabe, ein homogenes Projektionslichtbündel bereitzustellen, ist insofern nicht trivial, als die als Lichtquelle üblicherweise verwendeten Laser ein gaußförmiges Intensitätsprofil erzeugen, das durch nachfolgende optische Elemente in ein möglichst rechteckförmiges Intensitätsprofil überführt werden soll. Material- sowie Fertigungsfehler dieser optischen Elemente können dabei Inhomogenitäten der Intensitätsverteilung erzeugen. Bei diesen optischen Elementen kann es sich beispielsweise um Rasterelemente wie etwa Mikrolinsen-Arrays handeln, die zur Erhöhung des geometrischen optischen Flusses, zur Einstellung der Beleuchtungswinkelverteilung sowie zur Festlegung der Geometrie des auf der Maske ausleuchtbaren Lichtfeldes eingesetzt werden.

Häufig wird von Beleuchtungseinrichtungen außerdem gefordert, daß sie das Projektionslicht in einem gewünschten Polarisationszustand bereitstellen. Es hat sich nämlich herausgestellt, daß in bestimmten Fällen, z.B. bei der Projektion von Strukturen, die eine bestimmte Vorzugsrichtung haben, die Verwendung linear polarisierten Lichts zu einem höheren Kontrast bei der Abbildung der Strukturen führt. Daneben gibt es Fälle, in denen das Retikel nicht mit linear, sondern mit anders, z.B. zirkular, polarisiertem Licht oder aber mit Licht ohne jegliche Polarisationsvorzugsrichtung beleuchtet werden soll. Für die Beleuchtungseinrichtung bedeutet dies, daß die darin enthaltenen optischen Komponenten einen einmal eingestellten Polarisationszustand möglichst wenig stören sollten.

Aus der US 6 285 443 A ist eine Beleuchtungseinrichtung für eine mikrolithographische Projektionsbelichtungsanlage bekannt, bei der zur Lichtmischung ein Glasstab eingesetzt wird. Die Lichtmischung entsteht hier durch mehrfache Totalreflexion der durchtretenden Lichtstrahlen an den Mantelflächen des Glasstabs. Derartige Glasstäbe erhalten den Polarisationszustand des hindurchtretenden Lichts allerdings nicht.

Aus der EP 1 079 277 A1 ist eine Beleuchtungseinrichtung bekannt, die einen dort als Multiplexer bezeichneten Lichtmischer verwendet. Dieser bekannte Lichtmischer hat auch die Aufgabe, den zeitlichen und räumlichen Kohärenzgrad des Projektionslichts herabzusetzen. Hierzu werden durch mehrfache Strahlteilung Phasendifferenzen zwischen Lichtstrahlen eingeführt, welche die Kohärenzlänge des Projektionslichtes überschreiten. Die dabei verwendeten Strahlteiler stellen außerdem zusätzliche virtuelle räumlich getrennte Lichtquellen dar, wodurch auch die räumliche Kohärenz des Projektionslichts zerstört wird.

Der bekannte Lichtmischer weist zu diesem Zwecke eine in einer Ebene liegende Anordnung aneinander angrenzender Strahlteilerelemente auf, die jeweils eine auf einem Träger aufgebrachte dünne Schicht umfassen und unterschiedliche Reflexionsvermögen haben. Parallel zu dieser Ebene ist ein Planspiegel angeordnet, der von einem Strahlteilerelement reflektiertes Licht auf die jeweils benachbarte Strahlteilerschicht richtet.

Nachteilig bei diesem bekannten Lichtmischer ist, daß die Lichtintensitäten, denen die einzelnen Strahlteilerschichten ausgesetzt sind, erheblich zwischen den Strahlteilerschichten variieren. Diejenige Strahlteilerschicht, die dem einfallenden Lichtbündel ausgesetzt ist, degradiert in Folge von Alterungserscheinungen so rasch, daß in relativ kurzen Zeitintervallen ein Austausch erforderlich ist. Außerdem erhöht dieser bekannte Lichtmischer die Lichtquerschnittsfläche erheblich, was häufig unerwünscht ist.

### ZUSAMMENFASSUNG DER ERFINDUNG

Aufgabe der Erfindung ist es, eine Beleuchtungseinrichtung für eine mikrolithographische Projektionsbelichtungsanlage mit einem Lichtmischer anzugeben, der den Polarisationszustand hindurchtretenden Projektionslicht allenfalls geringfügig verändert und die Lichtquerschnittsfläche des Projektionslichtbündels bei dessen Durchtritt durch den Lichtmischer nicht zwangsläufig vergrößert.

Gemäß einem ersten Aspekt der Erfindung wird diese Aufgabe durch eine Beleuchtungseinrichtung mit einem Lichtmischer gelöst, der mindestens eine ebene Strahlteilerschicht umfaßt, die zwischen zwei transparenten Teilelementen parallel zu einer optischen Achse der Beleuchtungseinrichtung angeordnet ist.

Durch eine solche parallel zu einer optischen Achse der Beleuchtungseinrichtung angeordnete Strahlteilerschicht läßt sich eine Symmetrisierung eines einfallenden Lichtbündels erzielen, da ein Teil des Lichts die Strahlteilerschicht durchtreten kann, während ein anderer Teil davon reflektiert wird. Insbesondere dann, wenn auf den Lichtmischer zwei Lichtbündel symmetrisch auf eine durch die Strahlteilerschicht festgelegte Ebene zulaufen, kann auf diese Weise eine sehr gute Mischung der beiden Lichtbündel erzielt werden. Je mehr sich dabei das Transmissionsvermögen der mindestens einen Strahlteilerschicht deren Reflexionsvermögen annähert und je näher die Strahlteilerschicht der optischen Achse ist, desto vollständiger ist dabei die Symmetrisierung.

Unter einer Strahlteilerschicht wird hier im übrigen jede Schicht verstanden, welche die Eigenschaft hat, einen Teil des auftreffenden Lichts zu reflektieren und den übrigen Teil möglichst vollständig zu transmittieren. Der Absorptionsgrad der Strahlteilerschicht sollte daher möglichst klein, vorzugsweise kleiner als 5%, weiter vorzugsweise kleiner als 1%, sein.

Im allgemeinen umfassen derartige Strahlteilerschichten mindestens zwei Einzelschichten mit unterschiedlichen Brechzahlen. Bei Bedarf kann die mindestens eine Strahlteilerschicht polarisationsselektiv sein, falls der Lichtmischer den Polarisationszustand hindurchtretenden Lichts nicht nur erhalten, sondern gezielt verändern soll. Als polarisationsselektiv werden hier solche Strahlteilerschichten bezeichnet, bei denen sich im Gegensatz zu normalen Strahlteilerschichten, die nur eine sehr geringe Polarisationsselektivität haben, das Reflexionsvermögen für s-polarisiertes Licht um mehr als einen Faktor 2, vorzugsweise um mehr als einen Faktor 10, von dem Reflexionsvermögen für p-polarisiertes Licht unterscheidet.

Um eine Symmetrisierung nicht nur bezüglich einer Ebene, sondern bezüglich mehreren Ebenen zu erhalten, kann der Lichtmischer auch zwei oder mehr Strahlteilerschichten enthalten, die zwischen sich einen Winkel aufspannen. Im Falle von zwei Strahlteilerschichten sollte dieser Winkel vorzugsweise 90° betragen.

Im allgemeinsten Fall enthält der Lichtmischer n, n = 3, 4, 5, ..., Strahlteilerschichten, wobei zwei benachbarte Strahlteilerschichten einen Winkel von 360°/n aufspannen.

Die Teilelemente haben im wesentlichen nur die Aufgabe, als Träger der mindestens einen Strahlteilerschicht zu dienen. Aufgrund ihrer brechenden Wirkung beeinflussen sie allerdings auch die Richtung der den Lichtmischer durchtretenden Lichtstrahlen.

Die Teilelemente können deswegen so geformt sein, daß der Lichtmischer insgesamt eine von null verschiedene Brechkraft erhält und somit abbildend wirkt. Im allgemeinen wird es allerdings eher erwünscht sein, wenn der Lichtmischer insgesamt brechkraftfrei ist. Die Teilelemente sollten unter diesem Gesichtspunkt so geformt sein, daß der Lichtmischer für alle diesen durchtretenden Lichtstrahlen wie eine planparallele und daher brechkraftfreie Platte wirkt.

Im allgemeinen wird es sich deswegen bei den Teilelementen häufig um Prismen handeln, die so zusammengesetzt werden, daß der Lichtmischer zumindest im wesentlichen die Form eines Rhombus, eines Quaders und insbesondere die Form eines Würfels hat, wobei die optische Achse der Beleuchtungseinrichtung durch eine Kante oder auch durch eine Ecke des Quaders verläuft. Eine solche Form des Lichtmischers ist insbesondere dann vorteilhaft, wenn auf den Lichtmischer mehrere einzelne Lichtbündel aus unterschiedlichen Richtungen einfallen. In Beleuchtungseinrichtungen mikrolithographischer Projektionsbelichtungsanlagen ist dies beispielsweise in der Nähe von Pupillenebenen der Fall, die nur partiell, z.B. innerhalb von mehreren voneinander getrennten Polen, ausgeleuchtet werden.

Bei einer ringförmigen Ausleuchtung der Pupillenebene, wie sie bei einem sogenannten annularen Beleuchtungssetting auftritt, ist es hingegen günstiger, wenn der Lichtmischer eine Grundform hat, die durch zwei an ihren Basisflächen aneinander angrenzende gerade Kreiskegel mit vorzugsweise gleichem Öffnungswinkel beschreibbar ist. Für Licht, das mit einem ringförmigen Lichtquerschnitt auf einen solchen Lichtmischer fällt, ist dieser brechkraftfrei. Die Teilelemente, aus denen der Lichtmischer in diesem Fall zusammengesetzt ist, haben dann die Form von Kegelstumpfsegmenten.

Wird ein solcher Lichtmischer in einer Beleuchtungseinrichtung einer mikrolithographischen Projektionsbelichtungsanlage angeordnet, so kommt als Ort insbesondere eine Feldebene der Beleuchtungseinrichtung in Betracht. Die Feldebene sollte dann möglichst durch eine Symmetrieebene des Lichtmischers verlaufen.

Gemäß einem zweiten Aspekt der Erfindung wird die genannte Aufgabe durch eine Beleuchtungseinrichtung mit einem Lichtmischer zur Homogenisierung von Strahlungsverteilungen gelöst, der mindestens eine Reihe von Strahlteilern umfaßt, wobei in der mindestens einen Reihe die Strahlteiler
a) parallel zueinander verlaufen,
b) in einem Neigungswinkel zu einer eingangsseitigen optischen Achse des Lichtmischers angeordnet sind und
c) in einer zu der eingangsseitigen optischen Achse senkrechten Richtung versetzt hintereinander angeordnet sind.

Durch die erfindungsgemäße Anordnung mehrerer Strahlteiler, die z.B. einen transparenten Träger mit einer darauf aufgebrachten Strahlteilerschicht umfassen können, kann gewährleistet werden, daß jeder einzelne Lichtstrahl wenigstens zwei Strahlteiler durchtritt. Auf diese Weise wird jeder einfallende Lichtstrahl mehr als zweifach aufgeteilt, wodurch sich bei geeignet gewählten Abmessungen sowohl der zeitliche als auch der räumliche Kohärenzgrad erheblich herabsetzen läßt. Außerdem können alle Strahlteiler der eingangsseitig ersten Reihe gleichzeitig Licht ausgesetzt werden, wodurch die Geometrie der eingangsseitigen Lichtverteilung durch den Lichtmischer aufrecht erhalten werden kann. Der Lichtmischer ist daher besonders für Anwendungen geeignet, bei denen eine Vergrößerung der Lichtapertur unerwünscht ist.

Außerdem werden die Strahlteilerschichten bei dem erfindungsgemäßen Lichtmischer relativ gleichmäßig bestrahlt, wodurch es weniger schnell zu Degradationserscheinungen aufgrund hoher Strahlungsintensitäten kommt.

Falls der Lichtmischer keinen Versatz des Lichtbündels bewirkt, fällt die eingangsseitige optische Achse mit der ausgangsseitigen optischen Achse der Beleuchtungseinrichtung zusammen.

Am einfachsten liegen die Verhältnisse dann, wenn der Neigungswinkel der mindestens einen Reihe 45° beträgt. Ein parallel zur eingangsseitigen optischen Achse auf den Strahlteiler auftreffender Lichtstrahl wird dann in einen durchgehenden Teilstrahl und in einen durch Reflexion um 90° abgelenkten Teilstrahl aufgeteilt. Dies erlaubt eine rasterförmige Anordnung der einzelnen Strahlteiler innerhalb des Lichtmischers.

Der Lichtmischer gemäß diesem zweiten Aspekt kann außerdem als Teil eines Wabenkondensors verwendet werden, der die Eigenschaft hat, die zeitliche und räumliche Kohärenz des Lichts weitgehend zu zerstören.

Um eine möglichst gute Homogenisierung zu erzielen, sollten sich in Reihen, die entlang der eingangsseitigen optischen Achse aufeinander folgen, die Neigungswinkel jeweils betragsmäßig um 90° voneinander unterscheiden. Auf diese Weise wird eine homogene Intensitätsverteilung im Ausgangsbündel erzielt.

Enthält der Lichtmischer mindestens zwei hintereinander angeordnete Reihen von Strahlteilern, so ist sichergestellt, daß praktisch jeder in den Lichtmischer eintretende Lichtstrahl bei einem Durchtritt durch den Lichtmischer auf mindestens zwei Strahlteiler trifft. Etwas anderes gilt unter Umständen für Lichtstrahlen, die auf bestimmte Strahlteiler an den äußeren Rändern der Reihen auftreffen. Damit solche Lichtstrahlen nicht seitlich aus dem Lichtmischer entweichen, kann eine zusätzliche Umlenkeinrichtung vorgesehen sein, die Licht, das von einem äußersten Strahlteiler einer Reihe reflektiert wird, auf eine nachfolgende Reihe richtet. Eine solche Umlenkeinrichtung kann beispielsweise einen oder mehrere Planspiegel enthalten, die das Licht auf einen Strahlteiler einer nachfolgenden Reihe richten.

Wird der Lichtmischer mit kollimiertem Licht bestrahlt, so können die Strahlteiler so dicht angeordnet werden, daß der Lichtmischer eingangsseitig einem großflächigen Lichtquerschnitt ausgesetzt werden kann. Der Lichtmischer gemäß dem zweiten Aspekt der Erfindung erlaubt es jedoch auch, nicht kollimiertes Licht zu homogenisieren und dessen Kohärenzgrad zu verringern. Hierzu ist es lediglich erforderlich, daß zwischen mindestens zwei Strahlteilern ein optisches Element mit positiver Brechkraft angeordnet ist. Die optischen Elemente, bei denen es sich z.B. um Linsen oder diffraktive optische Elemente handeln kann, transportieren die Lichtapertur durch die Anordnung der Strahlteiler.

Vorzugsweise ist deswegen zwischen jeweils zwei entlang der eingangsseitigen optischen Achse oder senkrecht dazu benachbarten Strahlteilern ein optisches Element mit positiver Brechkraft angeordnet. Der Lichtmischer kann dann allerdings nicht mehr mit einem großflächigen Lichtquerschnitt bestrahlt werden, ohne das Licht, das auf die Zwischenräume zwischen den eingangsseitigen optischen E-Elementen fällt, durch Absorption oder Reflexion verloren geht. Um dies zu verhindern, kann der Lichtmischer eingangsseitig eine Abbildungseinheit enthalten, welche ein zusammenhängendes einfallendes Lichtbündel in Teillichtbündel aufteilt, die auf die eingangsseitigen Strahlteiler gerichtet werden. Die Abbildungseinheit kann hierzu beispielsweise ein Linsen-Array enthalten, das so viele Linsen enthält, wie Strahlteiler zu beleuchten sind. Die Abbildungseinheit kann auch mehrere hintereinander angeordnete Ebenen von Linsen enthalten. Um auch ausgangsseitig wieder ein zusammenhängendes Lichtbündel zu erhalten, kann dort ebenfalls eine entsprechende Abbildungseinheit vorgesehen sein.

### KURZE BESCHREIBUNG DER ZEICHUNGEN

Weitere Merkmale und Vorteile der Erfindung ergeben sich aus der nachfolgenden Beschreibung eines Ausführungsbeispiels anhand der Zeichnung. Darin zeigen:
- Figur 1: eine schematische und nicht maßstäbliche Darstellung einer Beleuchtungseinrichtung einer mikrolithographischen Projektionsbelichtungsanlage in einem Meridionalschnitt;
- Figur 2: eine perspektivische Darstellung eines in der Beleuchtungseinrichtung der Figur 1 gezeigten Lichtmischers gemäß einem ersten Ausführungsbeispiel;
- Figur 3: einen Schnitt durch den in der Figur 2 gezeigten Lichtmischer entlang der Linie III-III;
- Figur 4: eine perspektivische Darstellung eines für die Beleuchtungseinrichtung der Figur 1 geeigneten Lichtmischers gemäß einem zweiten Ausführungsbeispiel;
- Figur 5: einen Schnitt durch den in der Figur 4 gezeigten Lichtmischer;
- Figur 6: einen Schnitt durch den in den Figuren 4 und 5 gezeigten Lichtmischer entlang der Linie VI-VI;
- Figur 7: einen Meridionalschnitt durch einen Lichtmischer gemäß einem dritten Ausführungsbeispiel mit mehreren Reihen von Strahlteilern;
- Figur 8: eine vergrößerte Darstellung in dem Lichtmischer aus der Figur 7 enthaltenen Mischeinheit;
- Figur 9: einen vereinfachten Meridionalschnitt durch einen Lichtmischer gemäß einem vierten Ausführungsbeispiel mit mehreren Reihen von Strahlteilerwürfeln.

### BESCHREIBUNG BEVORZUGTER AUSFÜHRUNGSBEISPIELE

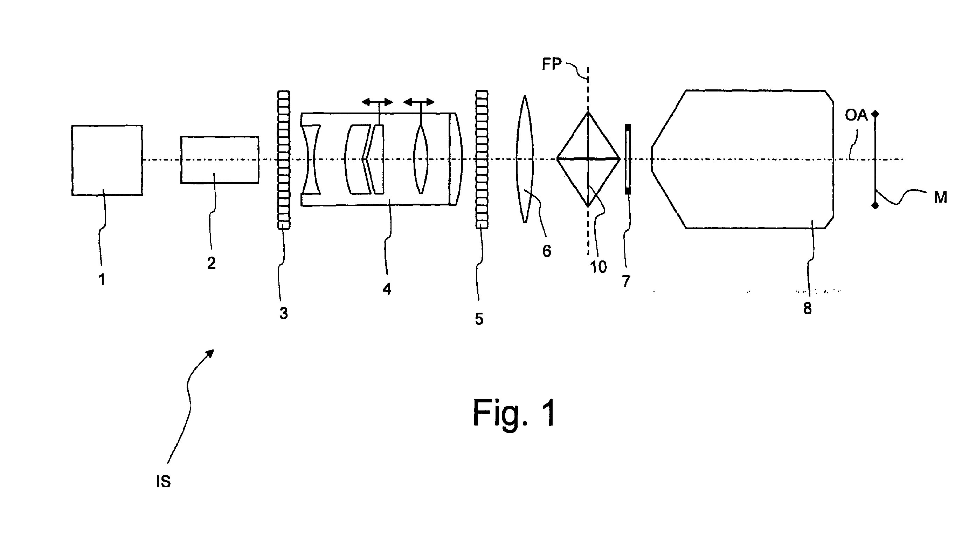

Die Figur 1 zeigt eine insgesamt mit IS bezeichnete Beleuchtungseinrichtung einer mikrolithographischen Projektionsbelichtungsanlage in einem stark vereinfachten und nicht maßstäblichen Meridionalschnitt. Die Beleuchtungseinrichtung IS umfaßt einen als Lichtquelle dienenden Laser 1, der ein kollimiertes Lichtbündel erzeugt, eine Strahlformungseinrichtung 2, ein erstes optisches Rasterelement 3, das erstmalig die Divergenz des Lichtbündels erhöht, ein Zoom-Axicon-Objektiv 4 zur Einstellung unterschiedlicher Beleuchtungsarten und ein zweites optisches Rasterelement 5. Im Strahlengang dahinter sind eine Kondensorlinse 6, ein Lichtmischer 10, durch den hindurch eine Feldebene FP verläuft, und eine verstellbare Maskierungseinrichtung 7 angeordnet, mit der sich die Geometrie des das Retikel durchtretenden Lichtfeldes festlegen läßt.

Die Beleuchtungseinrichtung IS umfaßt ferner ein Maskierungsobjektiv 8, in dessen Objektebene die Maskierungseinrichtung 7 und in dessen Bildebene eine Maske M angeordnet ist. Die Maskierungseinrichtung 7 wird somit von dem Maskierungsobjektiv 8 scharf auf die Maske M abgebildet und sorgt auf diese Weise für eine scharfe Berandung des Lichtfeldes.

Da die Beleuchtungseinrichtung IS insoweit bekannt ist, wird bezüglich näherer Einzelheiten auf die US 6 285 443 der Anmelderin sowie auf die darin zitierten Druckschriften verwiesen, die hiermit zum Gegenstand der vorliegenden Anmeldung gemacht werden. Die Verwendung hiervon abweichender Beleuchtungseinrichtungen, bei denen z.B. die Beleuchtungsarten auf andere Weise eingestellt werden, ist selbstverständlich ebenfalls möglich.

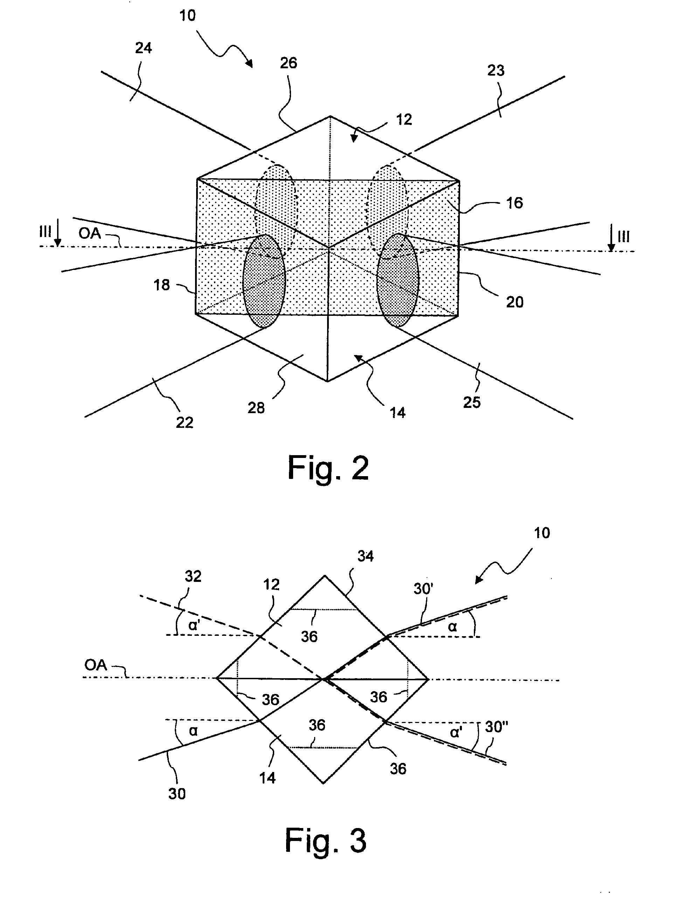

In der Figur 2 ist der Lichtmischer 10 perspektivisch dargestellt. Der Lichtmischer 10 umfaßt ein erstes Keilprisma 12 und ein zweites Keilprisma 14, deren Grundfläche jeweils die Form eines rechtwinkligen gleichschenkligen Dreiecks hat. Die beiden Keilprismen 12, 14 sind an ihren Hypotenusenflächen über eine Strahlteilerschicht 16 miteinander verbunden. Der Lichtmischer 10 hat dadurch insgesamt die Form eines Quaders mit quadratischer Grundfläche.

Die beiden Keilprismen 12, 14 bestehen jeweils aus einem Material, das für das verwendete Licht transparent ist. Die Strahlteilerschicht 16 umfaßt mehrere dünne dielektrische Einzelschichten, deren Brechzahlen in an sich bekannter Weise so aufeinander abgestimmt sind, daß die Strahlteilerschicht 16 annähernd zu gleichen Teilen auftreffendes Licht transmittiert und reflektiert. Das Absorptionsvermögen der Strahlteilerschicht 16 für das verwendete Licht sollte möglichst gering sein, so daß für das Transmissionsvermögen T und das Reflexionsvermögen R T = R ≈ 50% gilt.

Bei der in der Figur 2 gezeigten Anordnung ist der Lichtmischer 10 so orientiert, daß eine optische Achse OA der Beleuchtungseinrichtung durch die Strahlteilerschicht 16 hindurch verläuft. Kanten 18, 20 des Lichtmischers 10 werden daher von der optischen Achse OA durchsetzt.

Treffen nun zwei einfallende Lichtbündel 22, 24 symmetrisch zur Strahlteilerschicht 16 auf Kathetenflächen 26, 28 des Lichtmischers 10, so wirkt der Lichtmischer 10 aufgrund seiner Quaderform für die aus den Lichtbündeln 22, 24 bestehende Lichtverteilung insgesamt wie eine brechkraftfreie planparallele Platte. Der Lichtmischer 10 erzeugt daher zwar bestimmte Abbildungsfehler wie etwa sphärische Aberration und Koma, jedoch lassen sich diese Abbildungsfehler vergleichsweise einfach durch an sich bekannte Maßnahmen bei der Auslegung der Beleuchtungseinrichtung IS kompensieren. Auf rückwärtigen Kathetenflächen, die den eingangsseitigen Kathetenflächen 26, 28 gegenüber liegen, treten daher zwei Lichtbündel 23, 25 aus dem Lichtmischer 10 unter betragsmäßig gleichen Winkeln zur optischen Achse OA aus.

Mit Bezug auf die Figur 3 wird im folgenden erläutert, wie die zwischen den Keilprismen 12, 14 angeordnete Strahlteilerschicht 16 die auf den Lichtmischer 10 auftreffende Lichtverteilung symmetrisiert. Die Figur 3 zeigt eine Schnittdarstellung des Lichtmischers 10 entlang der Linie III-III. Die Schnittebene verläuft somit senkrecht zu der Strahlteilerschicht 16 und enthält die optische Achse OA.

In der Schnittdarstellung sind zwei Lichtstrahlen 30, 32 der einfallenden Lichtbündel 22 bzw. 24 mit durchgezogenen bzw. gestrichelt dargestellten Linien gezeigt. Der Einfachheit halber ist hier angenommen, daß die beiden Lichtstrahlen 30, 32 ebenfalls symmetrisch zu der Strahlteilerschicht 16 auf den Lichtmischer 10 auftreffen, und zwar unter Winkeln α bzw. α' zur optischen Achse OA, die betragmäßig gleich, aber entgegengesetzt orientiert sind. In der Figur 3 ist erkennbar, daß die beiden Lichtstrahlen 30, 32 beim Auftreffen auf die Keilprismen 12 bzw. 14 gebrochen werden und dann auf die zwischen den Keilprismen 12, 14 angeordnete Strahlteilerschicht 16 zulaufen. Der mit durchgezogener Linie angedeutete Lichtstrahl 30 durchsetzt mit etwa 50% seiner Intensität die Strahlteilerschicht 16 und tritt nach Brechung an einer rückwärtigen Kathetenseite 34 des ersten Keilprismas 12 als Teilstrahl 30' unter dem Winkel α aus dem Lichtmischer 10 aus. Für den transmittierten Teilstrahl wirkt der Lichtmischer 10 somit, wie bereits erwähnt, als planparallele Platte.

Mit etwa 50% seiner Intensität wird der Lichtstrahl 30 an der Strahlteilerschicht 16 reflektiert und wird als Teilstrahl 30" auf eine rückwärtige Kathetenfläche 36 des ersten Keilprismas 12 gelenkt. Nach Brechung an dieser Grenzfläche verläßt der reflektierte Teilstrahl 30" den Lichtmischer 10 unter dem Winkel α'.

Da die Verhältnisse für den zweiten einfallenden Lichtstrahl 32 genau umgekehrt sind, bewirkt der Lichtmischer 10 insgesamt eine Symmetrisierung der Strahlungsverteilung. Davon kann man sich überzeugen, wenn man beispielsweise annimmt, daß der zweite einfallende Lichtstrahl 32 eine geringere Intensität als der erste einfallende Lichtstrahl 30 hat. Da die aus der Aufteilung an der Strahlteilerschicht 16 hervorgehenden Teilstrahlen jeweils die gleiche Intensität haben, überlagert sich jeweils ein reflektierender und ein transmittierter Teillichtstrahl zu einem austretenden Lichtstrahl, dessen Intensität gleich der Hälfte der Summe aus den Intensitäten ist, die die beiden einfallenden Lichtstrahlen 30, 32 jeweils haben. Für eine Strahlteilerschicht 16, deren Reflexionsvermögen exakt gleich dem Transmissionsvermögen ist, ist die Symmetrisierung der Intensitäten der einfallenden Lichtstrahlen 30, 32 somit vollständig, und zwar unabhängig von der Größe der Differenz dieser Intensitäten.

Wie eine einfache Rechnung zeigt, wird die Symmetrisierung um so schwächer, je stärker das Reflexionsvermögen der Strahlteilerschicht 16 von deren Transmissionsvermögen abweicht. Dabei zeigt sich allerdings auch, daß bei kleineren Differenzen zwischen den Intensitäten der einfallenden Lichtstrahlen 30, 32 auch dann eine gute Symmetrisierung erzielt wird, wenn das Reflexionsvermögen der Strahlteilerschicht 16 nur ungefähr mit deren Transmissionsvermögen übereinstimmt.

Ist eine Symmetrisierung nur für einen bestimmten Polarisationszustand gewünscht, so kann die Strahlteilerschicht 16 auch polarisationsselektiv ausgeführt sein. Derartige polarisationsselektive Strahlteilerschichten sind ebenfalls im Stand der Technik bekannt, so daß es hierzu keiner näheren Ausführungen bedarf.

Wie besonders gut in der Schnittdarstellung der Figur 3 erkennbar ist, wird nicht das gesamte Volumen des Lichtmischers 10 von Licht durchsetzt. Diejenigen Bereiche, die nicht von Licht durchsetzt werden, können deswegen zur Materialersparnis weggelassen werden. In der Figur 3 ist durch gepunktet dargestellte Trennlinien 36 angedeutet, welche Bereiche der Keilprismen 12, 14 abgetrennt werden können, ohne daß die Wirkung des Lichtmischers 10 beeinträchtigt wird. Der Lichtmischer 10 hätte dann nicht die Form eines Quaders, sondern die Form eines Oktaeders.

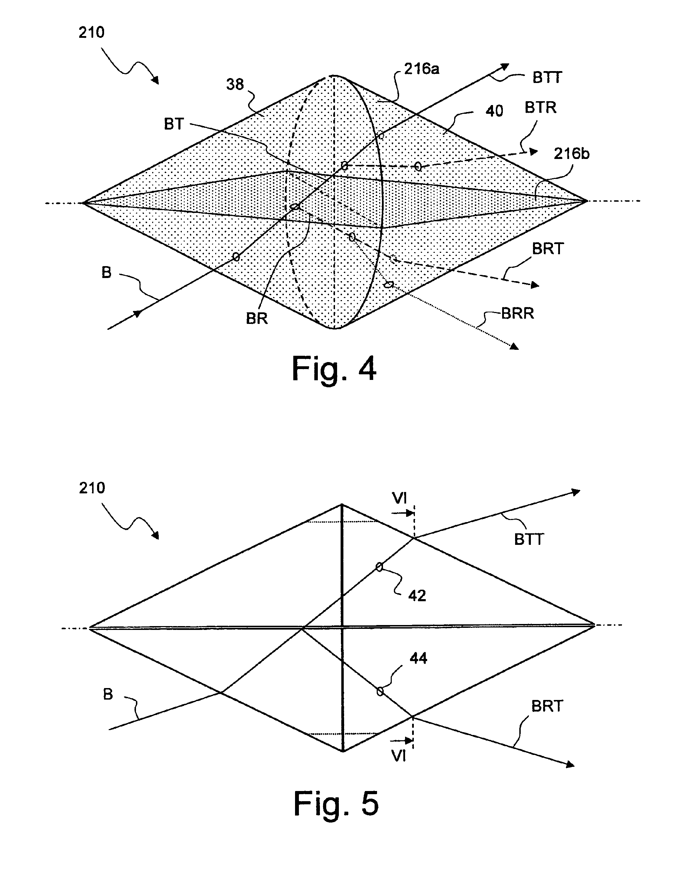

Die Figuren 4 bis 6 zeigen einen Lichtmischer 210 gemäß einem zweiten Ausführungsbeispiel der Erfindung in einer perspektivischen Darstellung, einer der Figur 2 entsprechenden Schnittdarstellung bzw. einem Schnitt entlang der Linie VI-VI. Gleiche oder einander entsprechende Teile sind dabei mit um 200 erhöhten Bezugsziffern bezeichnet.

Von dem in den Figuren 2 und 3 dargestellten Lichtmischer 10 unterscheidet sich der Lichtmischer 210 u.a. dadurch, daß dieser nicht nur eine Strahlteilerschicht, sondern zwei Strahlteilerschichten 216a, 216b enthält, die in der Figur 4 durch unterschiedlich dichte Punktierungen hervorgehoben sind. Die beiden Strahlteilerschichten 216a, 216b sind hier ebenfalls plan und haben die Eigenschaft, daß das Reflexionsvermögen annähernd gleich dem Transmissionsvermögen ist. Die beiden Strahlteilerschichten 216a, 216b sind senkrecht zueinander angeordnet, wobei die optische Achse OA durch die Schnittlinie der Strahlteilerschichten 216a, 216b verläuft.

Die Grundform des Lichtmischers 210 kann durch zwei gerade Kreiskegel 38, 40 beschrieben werden, deren Basisflächen aneinander angrenzen. Jeder der beiden Kreiskegel 38, 40 ist in vier nicht näher bezeichnete Kegelsegmente unterteilt, zwischen denen die beiden Strahlteilerschichten 216a, 216b verlaufen.

Im folgenden wird der Weg eines einfallenden Lichtstrahls B durch den Lichtmischer 210 beschrieben. Der unter einem Winkel zur optischen Achse OA auf den Lichtmischer 210 auftreffende Lichtstrahl B wird zunächst an einer Mantelfläche des Kegels 38 gebrochen und trifft bei der hier beispielhaft dargestellten Anordnung zunächst auf die zweite Strahlteilerschicht 216b. Der auf die zweite Strahlteilerschicht 216b auftreffende Lichtstrahl B wird an der zweiten Strahlteilerschicht 216b in einen durchgehenden Teilstrahl BT und einen reflektierten Teilstrahl BR aufgeteilt. Die beiden Teilstrahlen BT, BR treffen nun jeweils auf die erste Strahlteilerschicht 216a und werden dort jeweils erneut in zwei Teilstrahlen BTT, BTR sowie BRT, BRR aufgeteilt. Aus dem einfallenden Lichtstrahl 232 gehen daher insgesamt vier Teilstrahlen hervor, nämlich ein Teilstrahl BTT, der überhaupt nicht reflektiert wurde (durchgezogene Linie), zwei Teilstrahlen BTR und BRT, die jeweils einmal beim Durchtritt durch den Lichtmischer 210 reflektiert wurden (gestrichelt), und einen vierten Lichtstrahl BRR, der zweimal beim Durchtritt durch den Lichtmischer 210 reflektiert wurde (gepunktete Linie).

Die Figur 5 zeigt einen Schnitt durch den Lichtmischer 210, wobei die Schnittebene durch die Richtung des einfallenden Lichtstrahls B und das Lot auf der zweiten Strahlteilerfläche 216b aufgespannt wird. In der Figur 5 ist erkennbar, daß der durch die beiden Strahlteilerschichten 216a, 216b hindurchtretende Teilstrahl BTT und der nur an der zweiten Strahlteilerschicht 216b reflektierte Teilstrahl BRT eine ähnliche Konfiguration bilden wie die Strahlen 30, 30' und 30", die in der Figur 3 gezeigt sind. Die Teilstrahlen BTT und BRT haben allerdings, anders als die Strahlen 30', 30" bei dem Lichtmischer 10, lediglich ein Viertel der Intensität des einfallenden Strahls B. Die andere Hälfte der Intensität verteilt sich auf die beiden in der Figur 5 nicht erkennbaren Teilstrahlen BRT und BRR, die an den mit kleinen Ellipsen 42 bzw. 44 angedeuteten Stellen an der ersten Strahlteilerschicht 216a reflektiert und aus der Papierebene heraus gelenkt werden.

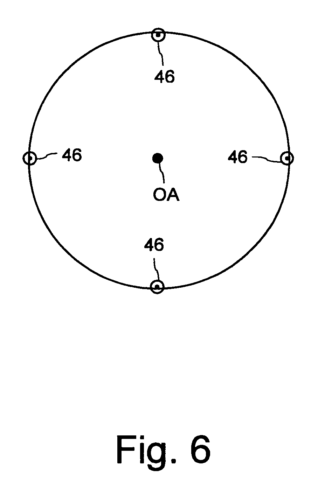

Die nicht in der Figur 5 erkennbaren Teilstrahlen BRT und BRR treten betragsmäßig unter dem gleichen Winkel zur optischen Achse OA aus dem Lichtmischer 210 aus, und zwar in einer Ebene, die durch Verkippen der Papierebene um eine vertikale Achse beschrieben werden kann. Die Punkte, an denen die Teilstrahlen BTT, BTR, BRT und BRR eine zur optischen Achse OA senkrechte Ebene den Lichtmischer 210 durchstoßen, sind in der Figur 6, die einen Schnitt entlang der Linie VI-VI durch den Lichtmischer 210 zeigt, durch kleine Kreise 46 angedeutet. Die optische Achse OA, die durch die Spitzen der Kegel 38, 40 verläuft, verläuft symmetrisch zu dieser Anordnung von Punkten.

Wie sich insbesondere aus den Figuren 5 und 6 ergibt, hat der Lichtmischer 210 eine ähnliche symmetrisierende Wirkung wie der Lichtmischer 10, jedoch mit dem Unterschied, daß die Wirkung insgesamt rotationssymmetrisch ist. Der Lichtmischer 210 ist aufgrund dieser Rotationssymmetrie besonders dazu geeignet, rotationssymmetrische Lichtverteilungen zu symmetrisieren. In Betracht kommen hier insbesondere ringförmige Lichtverteilungen, bei denen das Lichtbündel die Form einer Kegelmantelfläche hat. Derartige ringförmige Lichtverteilungen treten z.B. bei einem sogenannten annularen Beleuchtungssetting in der Nähe einer Pupillenebene der Beleuchtungseinrichtung IS auf.

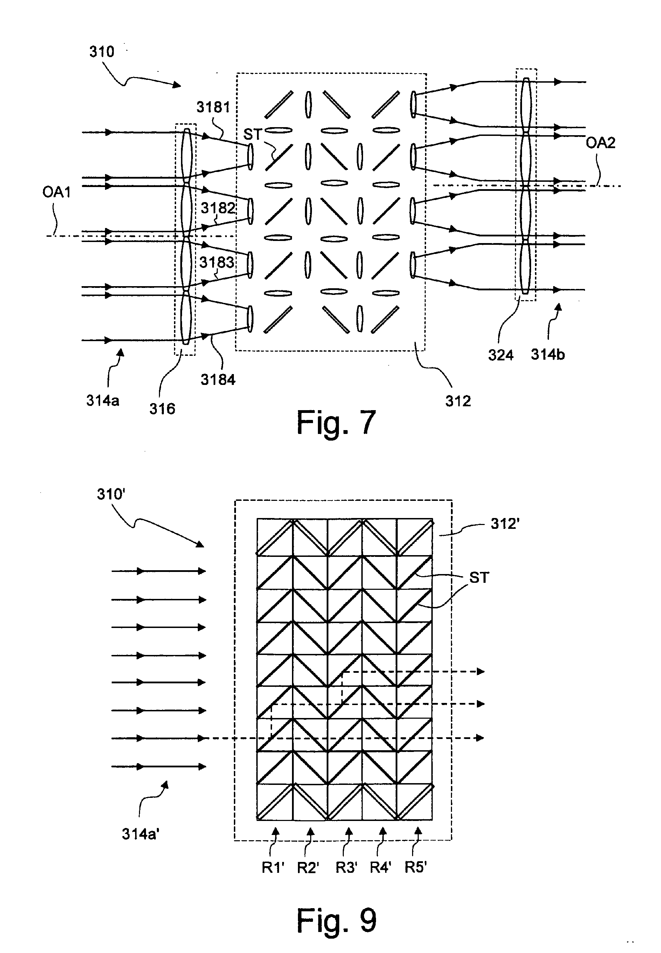

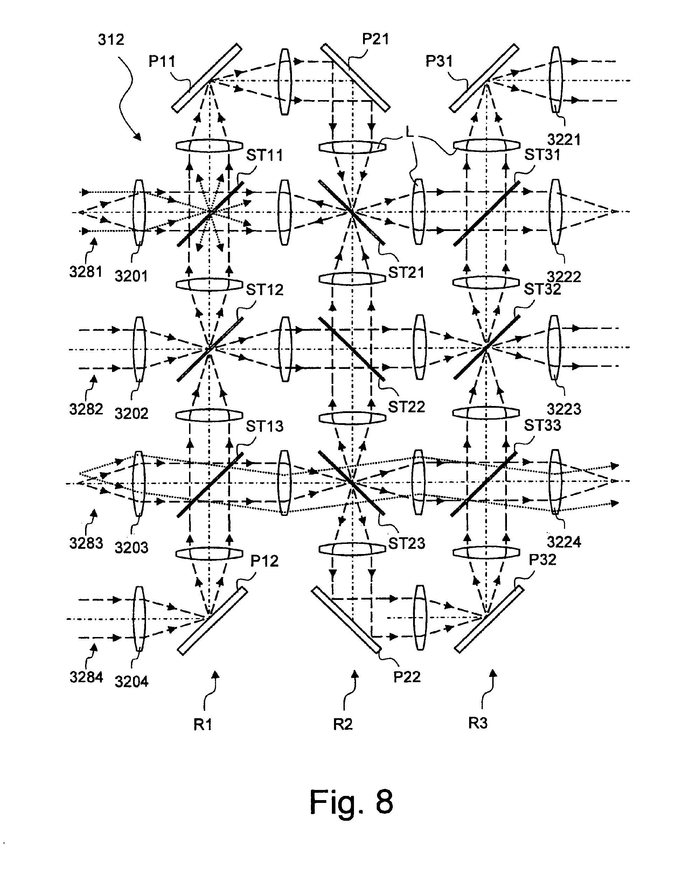

Die Figur 7 zeigt einen insgesamt mit 310 bezeichneten Lichtmischer gemäß einem anderen Aspekt der Erfindung. Ein einfallendes Lichtbündel 314a, das symmetrisch zu einer eingangsseitigen optischen Achse OA1 auf den Lichtmischer 310 fällt und nicht kolllimiert sein muß, durchtritt zunächst ein aus mehreren fugenlos aneinandergrenzenden Einzellinsen bestehendes Linsenraster 316. Das Linsenraster 316 unterteilt das einfallende Lichtbündel 314a in mehrere voneinander getrennte Teilbündel 3181, 3182, 3183 und 3184, die auf eine Mischeinheit 312 fallen, die vergrößert mit zusätzlichen Einzelheiten in der Figur 8 gezeigt ist.

Wie in der Figur 8 erkennbar ist, treffen die voneinander getrennten Teilbündel 3181 bis 3184 dort auf Eingangslinsen 3201, 3202, 3203 bzw. 3204, welche die Teilbündel 3181 bis 3184 auf eine erste Reihe R1 von Strahlteilern ST11, ST12, ST13 bzw. einen Planspiegel P12 richten. Die Strahlteiler ST11, ST12, ST13 enthalten jeweils eine auf eine dünne planparallele Trägerplatte aufgebrachte Strahlteilerschicht, die etwa 50% des einfallenden Lichts transmittiert und die übrigen 50% reflektiert.

Die drei Strahlteiler ST11, ST12 und ST13 sowie der Planspiegel P12 sind parallel zueinander angeordnet, und zwar jeweils in einem Winkel von 45° zu eingangsseitigen optischen Achse OA1. Hinter der ersten Reihe R1 von Strahlteilern ist eine zweite Reihe R2 von Strahlteilern ST21, ST22, ST23 angeordnet, die um 90° gegenüber den Strahlteilern der ersten Reihe R1 verkippt sind. Darauf folgt eine dritte Reihe R3 von Strahlteilern ST31, ST32, ST33, die wieder in der gleichen Weise wie die Strahlteiler der ersten Reihe R1 zu eingangsseitigen optischen Achse OA1 orientiert sind.

In der Figur 8 ist durch gestrichelte und gepunktete Linien, die einzelne Strahlen der Teilbündel 3181 bis 3184 andeuten, erkennbar, wie das durch die Eingangslinsen 3201 bis 3204 in die Mischeinheit 312 eintretende Licht durch mehrfache Teilung an den Strahlteilern ST in immer intensitätsschwächere Teilbündel unterteilt und schließlich über Ausgangslinsen 3221 bis 3224 die Mischeinheit 312 wieder verläßt. Ein zweites ausgangsseitiges Linsenraster 324 (siehe Figur 7) führt die aus der Mischeinheit 312 austretenden Teilbündel wieder zu einem gemeinsamen und jetzt homogenisierten Lichtbündel 314b zusammen. Der Lichtmischer 310 verändert den Querschnitt des auftreffenden Lichtbündels 314a nicht, sondern versetzt das Lichtbündel 314a lediglich parallel zur eingangsseitigen optischen Achse OA1. Eine ausgangsseitige optische Achse OA2 verläuft deswegen parallel, aber nicht kollinear zur eingangsseitigen optischen Achse OA1.

Da die infolge der mehrfachen Teilung entstehenden Teilstrahlen unterschiedlich lange Wege innerhalb der Mischeinheit 312 zurücklegen, hat das austretende Lichtbündel 314b einen deutlich herabgesetzten zeitlichen Kohärenzgrad. Daneben ist auch der räumliche Kohärenzgrad reduziert, da ein beispielsweise durch die Eingangslinse 3201 in die Mischeinheit 312 eintretender Lichtstrahl so aufgeteilt wird, daß die Teilstrahlen über alle Ausgangslinsen 3221 bis 3223 aus der Mischeinheit 312 austreten. Die Ausgangslinsen 3221 bis 3224 haben somit die Wirkung virtueller Lichtquellen, welche den räumlichen Kohärenzgrad des Lichts herabsetzen.

Je größer die Zahl der Strahlteiler ST ist, desto besser ist die homogenisierende Wirkung des Lichtmischers 312. Für die Verringerung des zeitlichen Kohärenzgrades kommt es allerdings nicht auf die Zahl der Strahlaufteilungen, sondern auf die optischen Weglängenunterschiede an, die zwischen Teilstrahlen bestehen, die aus einem einfallenden Strahl hervorgegangen sind. Diese Weglängenunterschiede sollten so gewählt sein, daß sie die Kohärenzlänge des einfallenden Lichts überschreiten. Bei einer Wellenlänge von 157 nm beträgt die Kohärenzlänge beispielsweise etwa 10 mm.

Damit an den äußeren Rändern in der Richtung senkrecht zu der eingangsseitigen optischen Achse OA1 kein Licht verlorengeht, sind bei der in der Figur 8 gezeigten Mischeinheit 312 in jeder der Reihen R1 bis R3 jeweils zwei Planspiegel P12 und P22, P21 und P22 sowie P31 und P32 vorgesehen. Die Planspiegel sind dabei jeweils genauso orientiert wie die Strahlteiler ST in der betreffenden Reihe, so daß benachbarte Planspiegel, z.B. die Planspiegel P11 und P21, eine Strahlumkehr in eine nachfolgende Reihe bewirken.

Bei dem dargestellten Ausführungsbeispiel ist angenommen, daß das auf den Lichtmischer 310 auftreffende Lichtbündel 314a nicht kollimiert ist, sondern eine von null verschiedene Divergenz hat. Daher ist es erforderlich, zusätzlich zu den Eingangslinsen 3201 bis 3204 und den Ausgangslinsen 3221 bis 3224 weitere mit L bezeichnete Linsen innerhalb der Mischeinheit 312 derart anzuordnen, daß die Lichtapertur durch die Mischeinheit 312 transportiert werden kann. In dem dargestellten Ausführungsbeispiel ist deswegen zwischen jeweils zwei benachbarten Strahlteilern ST oder Planspiegeln P jeweils eine Sammellinse L angeordnet, deren Brennweite f dem Abstand zwischen je einer Strahlteiler- oder Planspiegelmitte und der Linse L entspricht.

Falls das auf den Lichtmischer 310 auftreffende Lichtbündel 314a kollimiert ist, so besteht keine Notwendigkeit, zwischen den Strahlteilern ST Sammellinsen L anzuordnen. Die Strahlteiler ST können in diesem Fall nahtlos aneinander angefügt werden, wodurch sich die in der Figur 9 gezeigte Anordnung einer Mischeinheit 312' ergibt. Da die Strahlteiler der ersten Reihe R1' für ein Auftreffen des kollimierten Lichtbündels 314a' eine durchgehende Fläche bietet, sind bei dieser Anordnung der Strahlteiler ST auch keine eingangsseitigen und ausgangsseitigen Linsenraster 316 bzw. 324 erforderlich. Die in der Figur 9 gezeigte Anordnung der Strahlteiler ST erlaubt es außerdem, diese als kleine Strahlteilerwürfel auszuführen, die fugenlos aneinander angrenzen. Dieser sehr kompakte Aufbau erlaubt es, auf engem Raum sehr viele Reihen R1' bis R5' von Strahlteilern ST anzuordnen.

Es versteht sich, daß bei Lichtbündeln 314a, deren maximale Ausdehnung in zwei zueinander senkrechten Richtungen annähernd gleich sind, der Lichtmischer 310 oder 310' um zusätzliche Ebenen von Strahlteilern ergänzt werden kann, die gestaffelt in der zur Papierebene senkrechten Richtung hintereinander angeordnet sind. Soll eine Homogenisierung auch in der Richtung senkrecht zur Papierebene erzeugt werden, so kann dies beispielsweise dadurch erreicht werden, daß das aus dem Lichtmischer 310 oder 310' austretende Lichtbündel 314b einem zweiten Lichtmischer zugeführt wird, der genauso wie der Lichtmischer 310 oder 310' ausgeführt ist, jedoch um 90° um die optische Achse gedreht angeordnet ist.

Die in den Figuren 7 bis 9 gezeigten Lichtmischer 310 und 310' können ebenfalls in der Beleuchtungseinrichtung IS eingesetzt werden. Da der in den Figuren 7 und 8 gezeigte Lichtmischer 310 nicht die Verwendung kollimierten Lichts voraussetzt, ist auch eine Anordnung des Lichtmischers 310 hinter solchen optischen Elementen der Beleuchtungseinrichtung möglich, welche erstmals eine Strahlendivergenz eingeführt haben. In Betracht kommt deswegen z.B. auch die in der Figur 1 gezeigte Feldebene FP.

Der Lichtmischer 310' hingegen kann nur im parallelen Strahlengang verwendet werden. Als Position geeignet ist ein Ort noch vor dem ersten optischen Rasterelement 3, das die Divergenz des Projektionslichtbündels erstmalig erhöht, und vorzugsweise noch vor der Strahlformungseinrichtung 2, z.B. unmittelbar hinter dem Laser 1. Der Lichtmischer 310' homogenisiert dann das von dem Laser 1 erzeugte Projektionslicht, bevor dieses auf nachfolgende optische Elemente trifft.

## Patentansprüche

1. Beleuchtungseinrichtung einer mikrolithographischen Projektionsbelichtungsanlage mit einem Lichtmischer (10; 210) zur Homogenisierung von Strahlungsverteilungen, der mindestens eine ebene Strahlteilerschicht (16; 216a, 216b) umfaßt, die zwischen zwei transparenten Teilelementen (12, 14) parallel zu einer optischen Achse (OA) der Beleuchtungseinrichtung (IS) angeordnet ist.

2. Beleuchtungseinrichtung nach Anspruch 1, **dadurch gekennzeichnet, daß** das Transmissionsvermögen der mindestens einen Strahlteilerschicht (16; 216a, 216b) zumindest annähernd gleich deren Reflexionsvermögen ist.

3. Beleuchtungseinrichtung nach Anspruch 1 oder 2, **dadurch gekennzeichnet, daß** die mindestens eine Strahlteilerschicht (16; 216a, 216b) die optische Achse (OA) enthält.

4. Beleuchtungseinrichtung nach Anspruch 4, **dadurch gekennzeichnet, daß** zwei Strahlteilerschichten (216a, 216b) zwischen sich einen Winkel aufspannen.

5. Beleuchtungseinrichtung nach Anspruch 4, **dadurch gekennzeichnet, daß** der Winkel 90° beträgt.

6. Beleuchtungseinrichtung nach Anspruch 4 oder 5, **dadurch gekennzeichnet, daß** der Lichtmischer m, m = 3, 4, ..., Strahlteilerschichten enthält, wobei zwei benachbarte Strahlteilerschichten einen Winkel von 360°/m aufspannen.

7. Beleuchtungseinrichtung nach einem der vorhergehenden Ansprüche, **dadurch gekennzeichnet, daß** die Teilelemente (12, 14) alle die gleiche geometrische Grundform haben.

8. Lichtmischer nach Anspruch 7, **dadurch gekennzeichnet, daß** die Teilelemente (12, 14) Prismen sind.

9. Lichtmischer nach Anspruch 8, **dadurch gekennzeichnet, daß** der Lichtmischer (10) zumindest im wesentlichen die Form eines Quaders hat, wobei die optische Achse (OA) durch eine Kante (18, 20) des Quaders verläuft.

10. Beleuchtungseinrichtung nach Anspruch 9, **dadurch gekennzeichnet, daß** die optische Achse (OA) durch eine Ecke des Quaders verläuft.

11. Beleuchtungseinrichtung nach einem der Ansprüche 8 bis 10, **dadurch gekennzeichnet, daß** der Lichtmischer zumindest im wesentlichen die Form eines Würfels hat.

12. Beleuchtungseinrichtung nach einem der Ansprüche 1 bis 7, **dadurch gekennzeichnet, daß** der Lichtmischer (210) eine Grundform hat, die durch zwei an ihren Basisflächen aneinander angrenzende gerade Kreiskegel (38, 40) beschreibbar ist.

13. Beleuchtungseinrichtung nach Anspruch 12, **dadurch gekennzeichnet, daß** die Teilelemente die Form von Kegelsegmenten haben.

14. Beleuchtungseinrichtung nach einem der Ansprüche 1 bis 7, **dadurch gekennzeichnet, daß** der Lichtmischer zumindest im wesentlichen die Form eines Rhombus hat.

15. Beleuchtungseinrichtung nach einem der vorhergehenden Ansprüche, **dadurch gekennzeichnet, daß** die mindestens eine Strahlteilerschicht (16, 216a, 216b) mindestens zwei Einzelschichten mit unterschiedlichen Brechzahlen umfaßt.

16. Beleuchtungseinrichtung nach einem der vorhergehenden Ansprüche, **dadurch gekennzeichnet, daß** die mindestens eine Strahlteilerschicht eine polarisationsselektive Strahlteilerschicht ist.

17. Beleuchtungseinrichtung nach Anspruch 16, **dadurch gekennzeichnet, daß** das Reflexionsvermögen für s-polarisiertes Licht sich um einen Faktor 2, vorzugsweise um mehr als einen Faktor 10, von dem Reflexionsvermögen für p-polarisiertes Licht unterscheidet.

18. Beleuchtungseinrichtung nach Anspruch 17, **dadurch gekennzeichnet, daß** der Lichtmischer (10) in einer Feldebene (FP) der Beleuchtungseinrichtung (IS) angeordnet ist.

19. Beleuchtungseinrichtung nach Anspruch 18, **dadurch gekennzeichnet, daß** die Feldebene (FP) durch eine Symmetrieebene des Lichtmischers (10) verläuft.

20. Beleuchtungseinrichtung einer mikrolithographischen Projektionsbelichtungsanlage mit einem Lichtmischer (310; 310') zur Homogenisierung von Strahlungsverteilungen, der mindestens eine Reihe (R1 bis R3; R1' bis R5') von Strahlteilern (ST11, ST12, ST13, ST21, ST22, ST23, ST31, ST32, ST33) umfaßt, wobei in der mindestens einen Reihe die Strahlteiler
a) parallel zueinander,
b) in einem Neigungswinkel zu einer eingangsseitigen optischen Achse (OA1) der Beleuchtungseinrichtung (IS) und
c) in einer zu der eingangsseitigen optischen Achse (OA1) senkrechten Richtung versetzt hintereinander angeordnet sind.

21. Beleuchtungseinrichtung nach Anspruch 20, **dadurch gekennzeichnet, daß** der Neigungswinkel der mindestens einen Reihe (R1 bis R3; R1' bis R5') 45° beträgt.

22. Beleuchtungseinrichtung nach Anspruch 20 oder 21, **dadurch gekennzeichnet, daß** sich in Reihen (R1 bis R3; R1' bis R5'), die entlang der eingangsseitigen optischen Achse OA aufeinander folgen, die Neigungswinkel jeweils betragsmäßig um 90° voneinander unterscheiden.

23. Beleuchtungseinrichtung nach einem der Ansprüche 20 bis 22, **dadurch gekennzeichnet, daß** die Strahlteiler (ST11, ST12, ST13, ST21, ST22, ST23, ST31, ST32, ST33) so angeordnet sind, daß jeder in den Lichtmischer eintretende Lichtstrahl bei seinem Durchtritt durch den Lichtmischer (310; 310') auf mindestens zwei Strahlteiler trifft.

24. Beleuchtungseinrichtung nach einem der Ansprüche 20 bis 23, **dadurch gekennzeichnet, daß** zwischen jeweils zwei benachbarten Strahlteilern (ST11, ST12, ST13, ST21, ST22, ST23, ST31, ST32, ST33) ein optisches Element (L) mit positiver Brechkraft angeordnet ist.

25. Beleuchtungseinrichtung nach einem der Ansprüche 20 bis 24, **gekennzeichnet durch** eine eingangsseitige Abbildungseinheit (316), welche ein zusammenhängendes einfallendes Lichtbündel (314a) in Teillichtbündel (3181, 3182, 3183, 3184) aufteilt, die auf eingangsseitige Strahlteiler (ST11, ST12, ST13) gerichtet werden.

26. Beleuchtungseinrichtung nach einem der Ansprüche 20 bis 25, **gekennzeichnet durch** eine ausgangsseitige Abbildungseinheit (324), welche von ausgangsseitigen Strahlteilern (ST31, ST32, ST33) ausgehende Teillichtbündel zu einem zusammenhängenden Lichtbündel (314b) zusammenführt.

27. Beleuchtungseinrichtung nach einem der Ansprüche 20 bis 26, **gekennzeichnet durch** eine Umlenkeinrichtung (P11, P21, P21, P22, P32), die Licht, das einen äußersten Strahlteiler (ST11, ST34, ST31) einer Reihe (R1, R2, R3) durchtritt, auf eine nachfolgende Reihe richtet.

28. Beleuchtungseinrichtung nach Anspruch 27, **dadurch gekennzeichnet, daß** die Umlenkeinrichtung mindestens einen Spiegel (P11, P21, P21, P22, P32) umfaßt.

29. Beleuchtungseinrichtung nach einem der Ansprüche 20 bis 29, **dadurch gekennzeichnet, daß** der Lichtmischer (310; 310') im parallelen Strahlengang angeordnet ist.

30. Beleuchtungseinrichtung nach Anspruch 29, **dadurch gekennzeichnet, daß** der Lichtmischer (310') vor einem optischen Element (3) der Beleuchtungseinrichtung (IS) angeordnet ist, das die Divergenz der Strahlungsverteilung erstmalig erhöht.

31. Projektionsbelichtungsanlage mit einer Beleuchtungseinrichtung (IS) nach einem der vorhergehenden Ansprüche.
